# EUROPEAN PATENT SPECIFICATION

(11) **EP 2 184 574 B1**
(45) Date of publication and mention of the grant of the patent: **19.09.2012**
(21) Application number: 07792038.7
(22) Date of filing: 06.08.2007
(51) Int. Cl.: F27B 17/00, B02C 19/00, B02C 19/18

(54) **SILICON HEATING FURNACE**
SILIZIUMHEIZOFEN
FOUR DE CHAUFFAGE DE SILICIUM

(43) Date of publication of application: 12.05.2010
(73) Proprietor: Teoss CO., LTD., Tokyo 185-0012 (JP)
(72) Inventor: MURAI, Tsuyoshi, Kokubunji-shi Tokyo 185-0012 (JP); KONAKA, Toshinori, Kokubunji-shi Tokyo 185-0012 (JP)
(74) Representative: Waldren, Robin Michael
(86) International application number: PCT/JP2007/065368
(87) International publication number: WO 2009/019756

(56) References cited:
- JP-A- 2005 288 332

## Description

### BACKGROUND OF THE INVENTION

### Field of the Invention

The present invention relates to a silicon heating furnace for heating a raw material silicon in a method that breaking the raw material silicon into pieces by quenching after heating. Particularly, the present invention relates to a silicon heating furnace which is constructed by combining two semi-cylindrical furnaces.

### Description of the Related Art

Silicon wafers for semiconductors are produced through steps that (a) a step for producing a raw material silicon, (b) a step for producing a single-crystal silicon ingot (substantially cylindrical) from the raw material silicon, and (c) a step for slicing the single-crystal silicon ingot into discs.

For the step (b), well-known "Czochralski Method" (to be referred to as the CZ method) is generally used. The CZ method has some steps that a step for heat-melting the raw material silicon in a crucible, a step for dipping a rod of the single-crystal silicon (a seed) into the molten silicon, and a step for pulling the rod upwards and rotating at the same time. For the CZ method, the raw material silicon is required to be broken into pieces to be easily thrown into the crucible and to be melted in short time.

Because of such requests, some kinds of "method for breaking the raw material silicon effectively" have been developed; for examples, see Japanese Patent Laid-Open No. H10-15822. A breaking method described in this document has a step for heating a raw material silicon (polycrystalline silicon) rod up to 440 to 800°C, a step for generating cracks by quenching to less than 100 °C, and a step for breaking into pieces by impact.

According to this "method for breaking the raw material silicon", the raw material silicon is broken easily by hitting the raw material silicon against other raw material silicon, because internal cracks of the raw material silicon are generated by heating. Accordingly, it is not necessary to use hammers or the like for breaking the raw material silicon. This results that hard work is dispensed and contamination of the raw material silicon with hammers or the like is avoided. In heating, however, it is necessary to heat the raw material silicon in a heating furnace; there is another problem that the raw material silicon is contaminated with metal impurities diffused from construction material of the heating furnace.

Then a "heating furnace" which is described in Japanese Patent Laid-Open No. 2005-288332 is developed. The "heating furnace" has a cylindrical main body which is constructed with two semi-cylindrical housings. Inner surface of the main body is covered with a coat of quartz glass and parting surface of each housing is covered with a coat of titanium.

According to the "heating furnace" described in JP 2005-288 332, covering the inner surface of the main body and the parting surface of each housing with the coat, the diffusion of the metal impurities into the beating furnace and the contamination can be avoided. And by separating one of the housing from the other, a wide hatch for taking out and putting into the raw material silicon can be made.

However, because each of the housings of the "heating furnace" has a "rectangular" opening, a longer side of the "rectangular" opening can be deformed easily with heat expansion. The deformation of the longer side with heat expansion makes a gap at a joining surface of each of the housings. Heat in the furnace leaks through the gap with remarkable decrease of heat efficiency.

### Brief Summary of the Invention

An object of the present invention is to provide a silicon heating furnace which can avoid the contamination of the raw material silicon and the decrease of heat efficiency with the heat expansion.

In accordance with an aspect of the present invention, a silicon heating furnace 10 having a heating chamber S1 for containing raw material silicon 12 to be heated, comprising:
two semi-cylindrical furnaces 26a, 26b constructing the cylindrical silicon heating furnace by combining each other;
each of the semi-cylindrical furnaces 26a,26b having:
   a semi-cylindrical housing 34;
   a semi-cylindrical insulator 36 arranged in inner side of the housing 34;
   a heater 38 arranged in inner side of the insulator 36;
   a semi-cylindrical isothermal material 42 made of heat-resistant glass, and arranged in inner side of the heater 38 and heated by the heater 38, and constituting an inner wall of the heating chamber S1;
   radial direction separation preventing members 44 arranged in inner side of both ends of circumferential direction of the housing 34, and preventing a separation of the insulator 36 to radial direction by contacting at end faces of circumferential direction 36a of the insulator 36;
   end face of circumferential direction covers 46 fixed on the radial direction separation preventing members 44, and covering the end faces of circumferential direction 36a of the insulator 36; and
   cooling pipes for end faces of circumferential direction 48 through which cooling water passed arranged between the end faces of circumferential direction 36a of the insulator 36 and the end face of circumferential direction covers 46.

According to the present invention, because the insulator 36 is arranged between the housing 34 and the heater 38, the heat from the heater 38 is prevented from directly transferring to the housing 34 to keep a shape of the housing 34 against the strain of heat expansion. Further, because the circumferential direction cooling pipes 48 are arranged between the end faces of circumferential direction 36a of the insulator 36 and the end face of circumferential direction covers 46, the end faces of circumferential direction 36a of the insulator 36 can be cooled by the cooling pipes for the end face of circumferential direction 48 to keep a shape at the circumferential edge of the housing 34 against the strain of heat expansion.

Furthermore, covering the inner surface 36c of the insulator 36 with the isothermal material 42 and covering the end faces of circumferential direction 36a of the insulator 36 with the end face of circumferential direction covers 46 cause metal impurities diffused from the insulator 36 not to be diffused into the heating chamber S1. And using the isothermal material 42 made of heat-resistant glass causes metal impurities not to be diffused from the isothermal material 42 itself into the heating chamber S1.

Both of the end face of circumferential direction covers 46 and the cooling pipes for the end face of circumferential direction 48 may be made of titanium and may be welded to each other.

Using titanium which is hard to generate heat diffusion for the end face of circumferential direction covers 46 and the cooling pipes for the end face of circumferential direction 48 prevents the metal impurities from diffusing. And welding the end face of circumferential direction covers 46 and the cooling pipes for the end face of circumferential direction 48 causes the end face of circumferential direction covers 46 to be cooled effectively by the cooling pipes 48 and the cooling pipes 48 to be set easily by fixing the end face of circumferential direction covers 46 to the radial direction separation preventing members 44.

Seals 40 made of string of quartz fibers may be arranged toward axial direction between an inner surface of the end of circumferential direction of the insulator 36 and an outer surface of the end of circumferential direction of the isothermal material 42.

Sealing a clearance S3 between the insulator 36 and the isothermal material 42 with the seals 40 of string of quartz fibers causes the metal impurities diffused from the inner surface of the insulator 36 to be prevented from diffusing into the heating chamber S1 through the clearance S3.

Each of the two semi-cylindrical furnaces 26a, 26b may comprise axial direction separation preventing members 50 arranged at both ends of axial direction of the housing 34, preventing the insulator from being separated toward the axial direction by contacting to both end faces of axial direction 36b; supports 54a, 54b having fixing plates 108 fitted to the axial direction separation preventing members 50 and supporting plate 110a supporting the end of axial direction of the isothermal material 42; side panel cooling pipes 56 through which cooling water pass; side wall members 58 made of heat-resistant glass, covering the end faces of axial direction 36b and constituting inner walls of the heating chamber S1.

Arranging the side panel cooling pipes 56 as to contact to the supports 54a, 54b causes the supports 54a, 54b to be cooled and the axial direction separation preventing members 50 to which the supports 54a, 54b are attached to be cooled. Furthermore, the end faces of axial direction 36b of the insulator 36 which contact to the axial direction separation preventing members 50 are also cooled.

Covering the end faces of axial direction 36b of the insulator 36 with the axial direction separation preventing members 50 and the side wall members 58 causes the metal impurities differed from the insulator 36 to be prevented from diffusing to the heating chamber S1.

The supports 54a, 54b and the side panel cooling pipes 56 may be made of titanium and welded to each other.

In the present invention, by constructing the supports 54a, 54b and the side panel cooling pipes 56 with titanium which is difficult to diffuse, the diffusion of the metal impurities from these parts into the heating chamber S1 is prevented. And by welding the supports 54a, 54b and the side panel cooling pipes 56, the supports 54a, 54b are well cooled and arranged easily only with fixing the supports 54a, 54b to the axial direction separation preventing members 50.

According to the present invention, the heat of the heater 38 is prevented from transferring directly to the housing 34 by the insulator 36. Furthermore, the end faces of circumferential direction 36a of the insulator 36 are cooled efficiently by the cooling pipes for the end faces of circumferential direction 48. Therefore, the housing 34 is prevented from being high temperature. Especially, the end of circumferential direction of the housing 34 is prevented from deforming by heat expansion and generating a gap at the joint surface between the two semi-cylindrical furnaces 26a, 26b is avoided. As a result, preventing a leak of the heat of the heating chamber S1 through the gap causes a decreasing of the heating efficiency with the deforming by heat expansion to be avoided.

Furthermore, covering the inner surface 36c of the insulator 36 with the isothermal material 42 and covering the end faces of circumferential direction 36a of the insulator 36 with the end face of circumferential direction covers 46 cause the metal impurities diffused from the insulator 36 not to be diffused into the heating chamber S1. And the raw material silicon 12 heated in the heating chamber S1 is prevented from being contaminated with the metal impurities.

### Brief Description of the Drawings

Fig.1 is a perspective view of a silicon heating furnace.
Fig.2 is a side view of a silicon heating furnace.
Fig.3 is a sectional view of an opened silicon heating furnace.
Fig.4 is an enlarged view of an end face of axial direction of a parting surface of a silicon heating furnace.
Fig.5 is a schematic view of a silicon heating furnace in-use.
Fig.6 is an exploded perspective view of a semi-cylindrical furnace (radial direction)
Fig.7 is an exploded perspective view of a semi-cylindrical furnace (axial direction)
Fig.8 is a perspective view of an insulator fixing structure.
Fig.9 is a perspective view of a fixing structure of a cover for an end face of circumferential direction and cooling pipes for an end face of circumferential direction.
Fig.10 is a perspective view of a fixing structure of a fitting plate.
Fig.11 is a perspective view of a fixing structure of supports and side panel cooing pipes.
Fig.12 is an enlarged view of "XII" part of Fig.11.
Fig.13 is a perspective view of a fixing structure of a side wall member and a cover.
Fig.14 is an enlarged view of "XIV" part of Fig.13.

### Detailed Description of the Invention

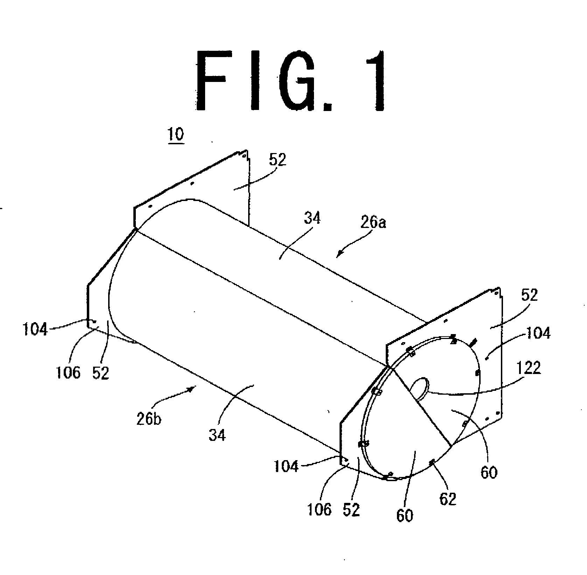

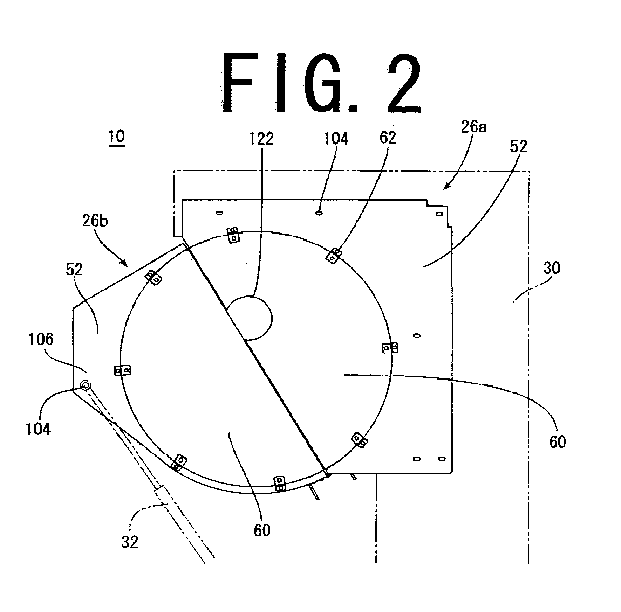

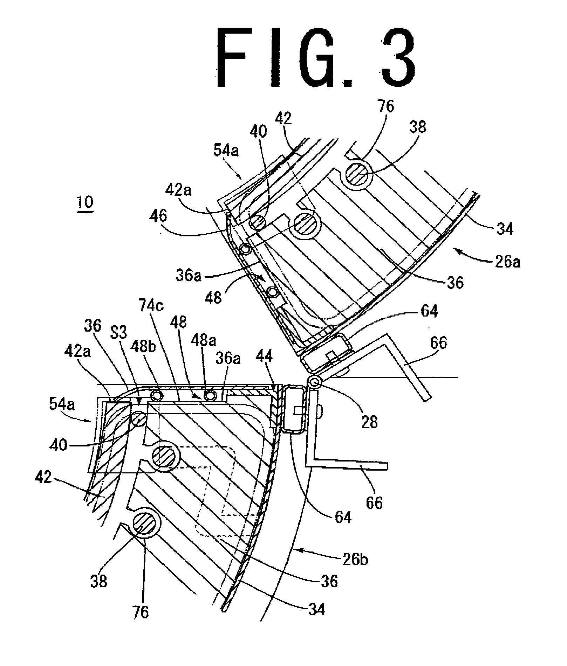

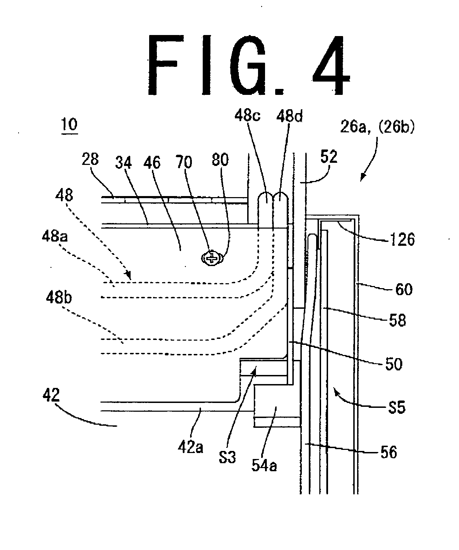

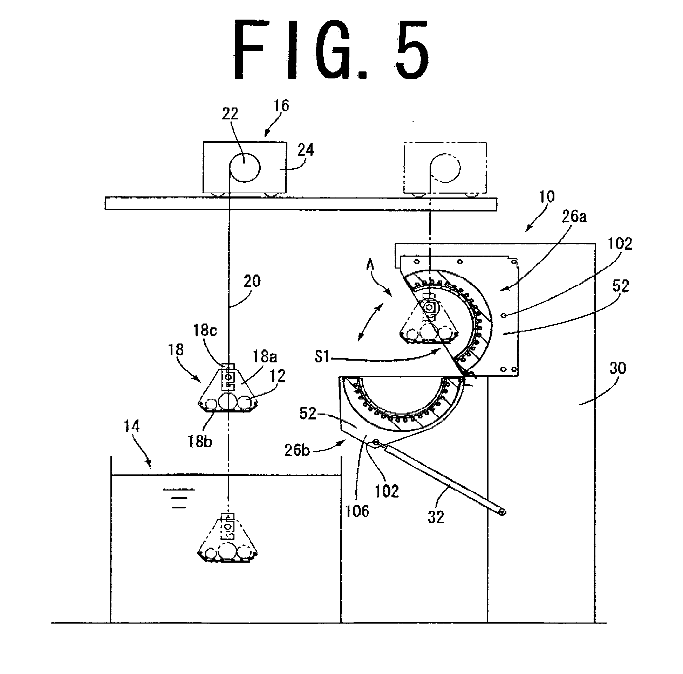

Fig.1 is a perspective view of a silicon heating furnace 10 in accordance with an embodiment of the present invention. Fig.2 is a side view of the silicon heating furnace 10. Fig.3 is a sectional view of the opened silicon heating furnace 10. Fig.4 is an enlarged view of an end face of axial direction of a parting surface of the silicon heating furnace 10. And Fig.5 is a schematic view of the silicon heating furnace 10 in-use.

The silicon heating furnace 10 heats a raw material silicon 12 up to high temperatures of 440-1000°C in a method for breaking the raw material silicon by quenching after heating. As shown in Fig.5, the silicon heating furnace 10 is used in a combination with a cooling water tank 14 for quenching the raw material silicon 12 and a conveyer 16 for conveying the raw material silicon 12.

The conveyer 16 (Fig.5) includes a basket 18 for being loaded the raw material silicon 12, a wire 20 for suspending the basket 18, a winch 22 for winding and unreeling the wire 20, and travelling device 24 for travelling the winch 22 in a horizontal direction. For quenching the raw material silicon 12 after heating, the basket 18 which is loaded the raw material silicon 12 is conveyed into the silicon heating furnace 10 at the beginning. Then the basket 18 is immersed into the water of the cooling water tank 14.

The basket 18 (Fig.5) of the conveyer 16 includes a pair of side plates 18a arranged to face each other, and pipes 18b bridged between the side plates 18a and loaded the raw material silicon 12. Each of the side plates 18a has a wire connector 18c on its upper side. The wire 20 is connected to the wire connectors 18c. A size of a heating chamber S1 and an open-close mechanism of a opening A of the silicon heating furnace 10 is designed in consideration of the relation with the basket 18 and wire 20.

The silicon heating furnace 10 (Fig.1-5) is a cylindrical furnace which has a heating chamber S1 (Fig.5) for being placed the basket 18. The silicon heating furnace 10 is constructed with two semi-cylindrical furnaces 26a, 26b with using hinges 28 (Fig.3). In use of the silicon heating furnace 10, as shown in Fig.5, one semi-cylindrical furnace 26a is fixed to a support 30, and a hydraulic cylinder 32 is fixed to the other semi-cylindrical furnace 26b. The opening between the two semi-cylindrical furnaces 26a, 26b (= the opening A) is opened and closed with the hydraulic cylinder 32.

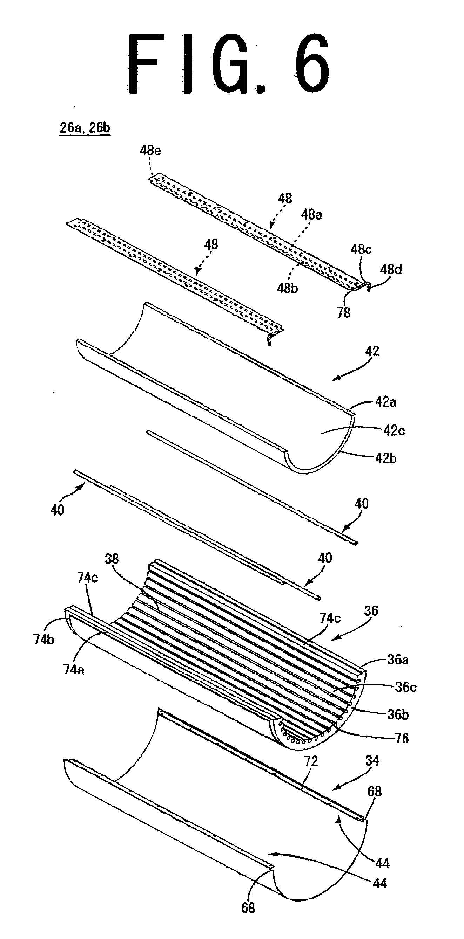

Each of the semi-cylindrical furnaces 26a, 26b has a semi-cylindrical housing 34, as shown in Fig.1, 3, and 4. An insulator 36, heaters 38, seals 40, and a isothermal material 42 are built onto an inside of the housing 34 in this order, as shown in Fig.6. Radial direction separation preventing members 44 for preventing the insulator 36 from separating to the radial direction are arranged on each inner surface of both end of circumferential direction. And end face of circumferential direction covers 46 for covering both end faces of circumferential direction of the insulator 36 are fixed to the Radial direction separation preventing members 44. Cooling pipes for end face of circumferential direction 48 are arranged between the end faces of circumferential direction 36a of the insulator 36 and each end face of circumferential direction covers 46.

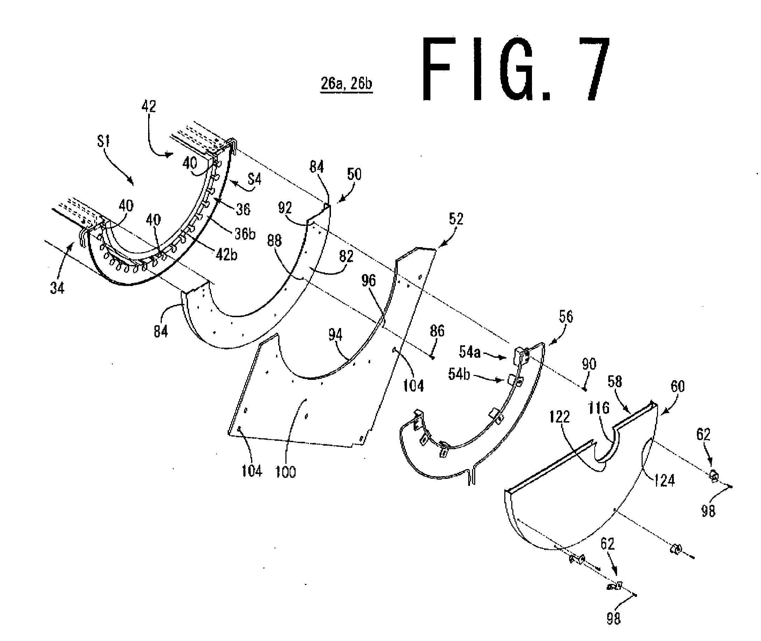

Axial direction separation preventing members 50 for preventing the insulator 36 from separating to the axial direction are fixed to both ends of axial direction of the housings 34, as shown in Fig.7. Fitting plates 52 and two kinds of supports 54a, 54b are fixed on the face of the axial direction separation preventing members 50. Side panel cooling pipes 56 are abut to the supports 54a, 54b- Furthermore, side wall members 58 for covering the end faces of axial direction 36b of the insulator 36 and the end faces of axial direction 42b of the isothermal material 42 from face side of the axial direction separation preventing members 50 and being inner wall of the heating chamber S1 are fixed on the face of the fitting plates 52 with covers 60 by means of fixing brackets 62.

On outer surface of one end of circumferential direction of the housing 34, as shown in Fig.3, square pipes 64 are arranged along to edges of circumferential direction of the housings 34. The pipe 64 for one semi-cylindrical furnace 26a and the pipe 64 for the other semi-cylindrical furnace 26b are connected each other by the hinges 28. And L-shaped reinforcing bar 66 for preventing the housing 34 from deforming is fixed to each of the pipes 64.

Hereinafter, each of parts for the silicon heating furnace 10 is explained in detail with reference to figures.

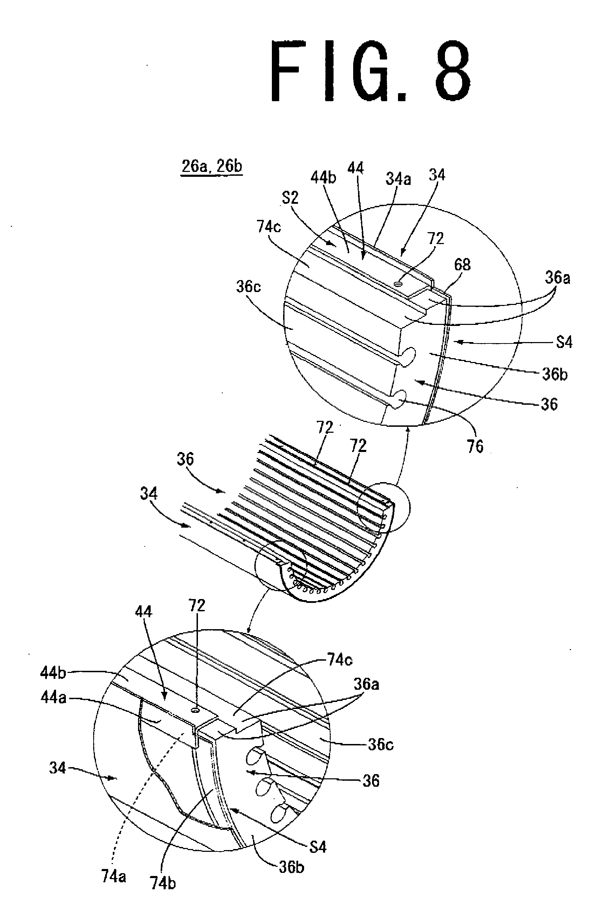

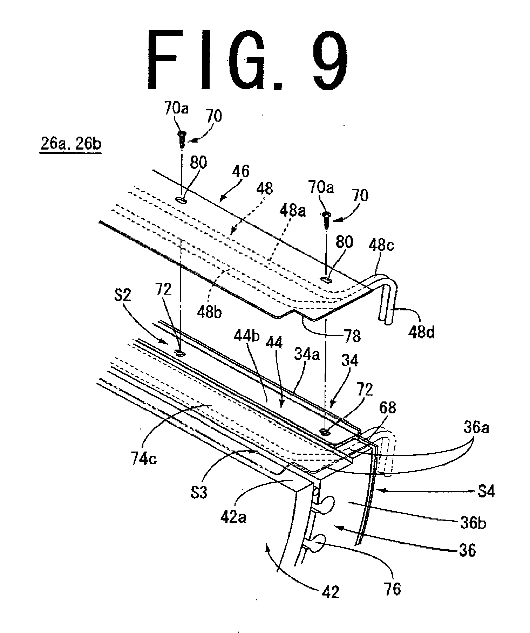

The housings 34 construct the outer wall of each of semi-cylindrical furnaces 26a, 26b. The housings 34 are made of semi-cylindrically bended metal such as stainless steel or the like. As shown in Fig.8 and Fig.9, cut-out 68 through which both ends 48c, 48d of the cooling pipes for end face of circumferential direction 48 pass are arranged at both edge of circumferential direction of one end of axial direction of the housing 34. As shown in Fig.6 and Fig.8, radial direction separation preventing members 44 are fixed by weld or screws at inner surfaces of both ends of circumferential direction of the housing 34, not at the cut-out 68.

The radial direction separation prevention members 44, as shown in Fig.8, prevent the insulator 36 from separating to radial direction by contacting to the end faces of circumferential direction 36a of the insulator 36. Each of the radial direction separation prevention members 44 includes a housing fixing piece 44a which is fixed to the housing 34 and a cover fixing piece 44b to which the end face of circumferential direction cover 46 is fixed (Fig.9). Therefore, each of the radial direction separation prevention members 44 has "L" shape. Several screw holes 72 for screws 70 (Fig.9) are arranged on the cover fixing piece 44b at specified intervals in a longitudinal direction.

In the state that the housing fixing piece 44a is fixed to the housing 34, a space S2 for being placed the end face of circumferential direction cover 46 and a head portion 70a of the screw 70 between the surface (to be fixed) of the cover fixing piece 44b and the end face of circumferential direction 34a of the housing 34. Therefore, the end face of circumferential direction cover 46 and the head portion 70a of the screw 70 do not stick out from the end face of circumferential direction 34a of the housing 34, and do not make the assembling the two semi-cylindrical furnaces 26a, 26b to one cylinder difficult.

The insulator 36 prevents the heat of the heaters 38 from transferring directly to the housings 34. As shown in Fig.6, the insulator 36 is constructed by making a heat-resistant insulating material such as alumina fiber cotton or the like semi-cylindrical shape. On outer surfaces of both ends of circumference direction of the insulator 36, as shown in Fig.6 and Fig.8, steps 74a for being arranged the housing fixing pieces 44a of the radial direction separation preventing members 44 are formed. On the outer surfaces of both ends of axial direction of the insulator 36, steps 74b for being arranged contact pieces 84 (Fig.7) of the axial direction separation preventing members 50 are formed. On the end faces of circumferential direction 36a of the insulator 36, steps 74c for being arranged approaching pipes 48a and returning pipes 48b (Fig.9) of cooling pipes for an end face of circumferential direction 48 are formed. Furthermore, on an inner surface 36c of the insulator 36, several recesses 76 extending to axial direction at specified circumferential direction intervals. The heaters 38 are placed into the recesses 76. (Fig.3)

In a state that the insulator 36 is arranged in the inner side of the housing 34, as shown in Fig.8, the cover fixing pieces 44b of the radial direction separation preventing members 44 are arranged as to face to the end faces of circumferential direction 36a of the insulator 36 and the housing fixing pieces 44a of the radial direction separation preventing members 44 are arranged at the steps 74a of the insulator 36. Therefore, no gap is generated between the housing 34 and the insulator 36.

The heaters 38 (Fig.3) are bar or line resistance heaters. And the heaters 38 are uniformly-distributed on the inner surface 36c of the insulator 36. These heaters 38 are electrically connected to terminals (not shown) arranged on the outer surface of the housing 34. The terminals supply power to the heaters 38 in-use.

The seals 40 are cords made of quartz fibers. As shown in Fig.6 and Fig.7, the seals 40 are arranged with extending to axial direction between the inner surfaces of both ends of circumferential direction of the insulator 36 and the outer surfaces of both ends of circumferential direction of the isothermal material 42, between a central portion of the inner surface of the insulator 36 and a central portion of the outer surface of the isothermal material 42. Consequently, gaps between the insulator 36 and the isothermal material 42 at the both ends of circumferential direction cause the diffusion of the metal impurities to be prevented from the inner surface of the insulator 36 into the heating chamber S1 through the gaps. And the seals 40 prevent the insulator 36 from contacting directly to the isothermal material 42. As a result, the insulator 36 and the isothermal material 42 are kept from damaging by contacting each other.

The isothermal material 42 is semi-cylindrical heat-resistant glass such as quartz glass or the like. And the isothermal material 42 constructs the inner wall of the heating chamber S1 and is heated uniformly with heat from the heaters 38. The end surfaces of circumferential direction 42a of the isothermal material 42, as shown in Fig.9, are set to be same level to the end faces of circumferential direction 36a (the step 74c) of the insulator 36.

The heat-resistant glass for the isothermal material 42 is no diffusion of metal impurities and high heat-resistance. Consequently, the construction that the isothermal material 42 is arranged in the inner side of the insulator 36 and the heaters 38 prevents the diffusion of the metal impurities from the insulator 36 into the heating chamber S1, the diffusion of the metal impurities from the isothermal material 42 itself, and radiates the heat from the heaters 38 to the heating chamber S1 through the isothermal material 42 uniformly.

The end face of circumferential direction covers 46 prevent the metal impurities from the insulator 36 from diffusing into the heating chamber S1 with covering the end faces of circumferential direction 36a of the insulator 36. As shown in Fig-6 and Fig.9, each of the end face of circumferential direction covers 46 is band-shaped high heat-resistant and low heat-diffusion material such as titanium or the like. A cut-out 78 for preventing from contacting to the support 54a is arranged at the portion in a longitudinal direction of each of the end face of circumferential direction covers 46 that faces to the end face of circumference direction 42a of the isothermal material 42. Holes 80 for screws 70, as shown in Fig.9, are prepared on the places that correspond to the screw holes 72 on the radial direction separation preventing member 44.

The holes 80 are elongate holes which are elongated in a longitudinal direction of the end face of circumferential direction covers 46. Consequently, the end face of circumferential direction covers 46 can be adjusted in its longitudinal direction after the screws 70 are fastened to the screw holes 72 on the radial direction separation preventing members 44.

When the end face of circumferential direction covers 46 are fixed to the radial direction separation preventing members 44, one end of width direction of each of the end face of circumferential direction covers 46, as shown in Fig.9, is arranged on a surface of the cover fixing piece 44b of the radial direction separation preventing member 44. And the other end of width direction of each of the end face of circumferential direction covers 46, as shown in Fig.3 and Fig.9, is bended in a direction to approach the end face of circumferential direction 42a of the isothermal material 42 as to face to the end face of circumferential direction 42a. The end face of circumferential direction covers 46 cover not only the end faces of circumferential direction 36a of the insulator 36 but gaps S3 (Fig.9) between the insulator 36 and the isothermal material 42. As a result, the metal impurities diffused from the insulator 36 are prevented from diffusing into the heating chamber S1 steadily.

The cooling pipes for end face of circumferential direction 48 are "pipes for passing water" constructed by bending high heat-resistant and low heat-diffusion pipes (titanium or the like) substantially "U"-letter in shape. As shown in Fig.6 and Fig.9, the cooling pipes 48 are arranged to extend the entire length of the end face of circumferential direction 36a between the end faces of circumferential direction 36a of the insulator 36 and the end face of circumferential direction covers 46. In other words, the approaching pipes 48a and the returning pipes 48b of the cooling pipes for end face of circumferential direction 48 are set parallel each other and contacted to the steps 74c of the end faces of circumferential direction 36a. Bending portions 48e (a boarder of the approaching pipe 48a and the returning pipe 48b) of the cooling pipes 48 (Fig.6) are arranged at one end of longitudinal direction of the end faces of circumferential direction 36a. Both ends 48c, 48d of the cooling pipes 48 are stuck out through the cut-out 68 of the housing 34 at the other ends of longitudinal direction of the end faces of circumferential direction 36a.

The cooling pipes for end face of circumferential direction 48 and the end face of circumferential direction covers 46 may be set separately. In this embodiment, the cooling pipes for end face of circumferential direction 48 are welded on the reverse of the end face of circumferential direction covers 46- Consequently, a positioning of the cooling pipes 48 for end face of circumferential direction 48 and a fixing of the end face of circumferential direction covers 46 to the radial direction separation preventing members 44 can be done at one time. As a result, the positioning of the cooling pipes 48 can be easily done. And the end face of circumferential direction covers 46 can be cooled efficiently with the cooling pipes for end face of circumferential direction 48.

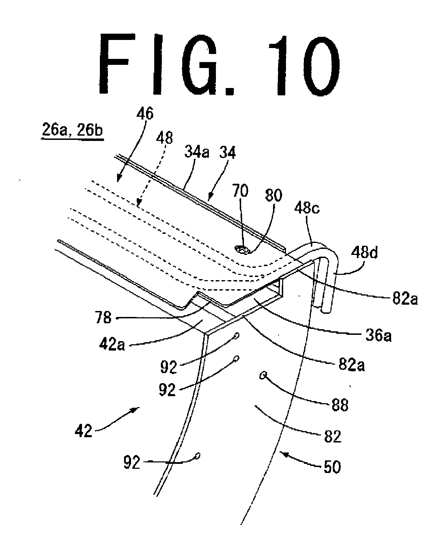

The axial direction separation preventing members 50 prevent the insulator 36 from separating to axial direction by contacting to the end faces of axial direction 36b of the insulator 36. As shown in Fig.7, each of the axial direction separation preventing members 50 includes a contact board 82 contacting to the end face of axial direction of the insulator 36 and a contact piece 84 rising up at rights from outer edge of the contact board 82. The contact board 82 is substantially "U"-letter in shape. An outer diameter of the contact board 82 is substantially the same as an inner diameter of the housing 34. And as shown in Fig.10, a step is prepared at an end face of circumferential direction 82a of the contact board 82. An outer part of the end face of circumferential direction 82a is set the same level as the end face of circumferential direction 34a of the housing 34. An inner part of the end face of circumferential direction 82a is set the same level as the end face of circumferential direction 36a, 42a of the insulator 36 and the isothermal material 42 respectively. The contact board 82 includes several holes of screw 88 which are fastened with several fixing screws 86 (Fig.7) and several holes of screw 92 which are fastened with several fixing screws 90. After inserting the contact piece 84 (Fig.7) into a gap S4 between housing34 and the step 74b (Fig.6 and Fig.8) of the insulator 36, this contact piece 84 is welded to the housing 34.

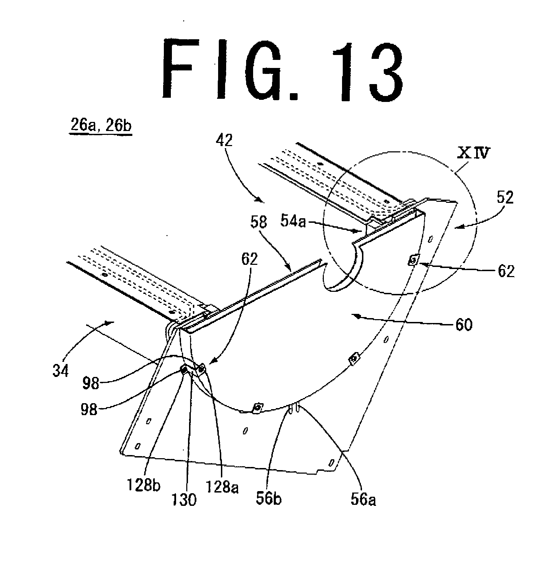

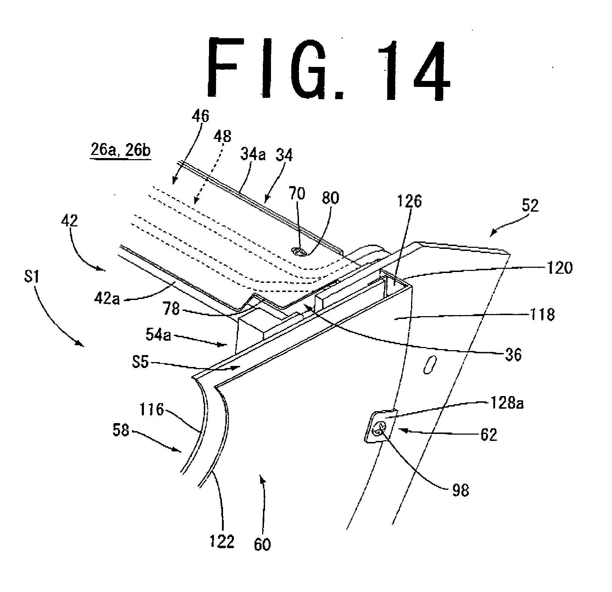

Each of the fitting plates 52, as shown in Fig.7, has a half-round cut-out 94 on a part of a board. Each of the fitting plates 52 includes several holes 96 which are fastened with several fixing screws 86, several holes of screw 100 which are fastened with several fixing screws 98 (Fig.13 and Fig.14), and several holes 104 through which several fixing screws 102 pass (Fig.5). The fitting plates 52 are fixed to the axial direction separation preventing members 50 with the fixing screws 86.

In addition, as shown in Fig.2 and Fig.5, shapes of the fitting plates 52 for the semi-cylindrical furnaces 26a and 26b are different each other. The shape of the fitting plate 52 for one semi-cylindrical furnace 26a is corresponded to the shape of the support 30. The shape of the fitting plate 52 for the other semi-cylindrical furnace 26b is considered as to keep an area for a fixing part 106 for fixing the hydraulic cylinder 32.

The supports 54a and 54b are for supporting the edge of axial direction of the isothermal material 42. The shapes of the supports 54a and 54b are selected depending on the shape of places to be supported.

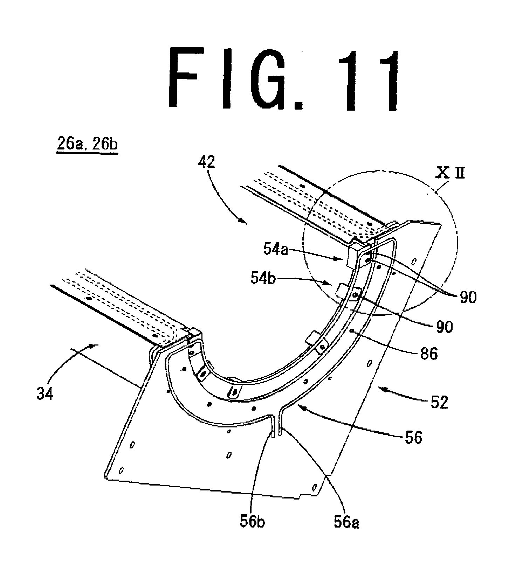

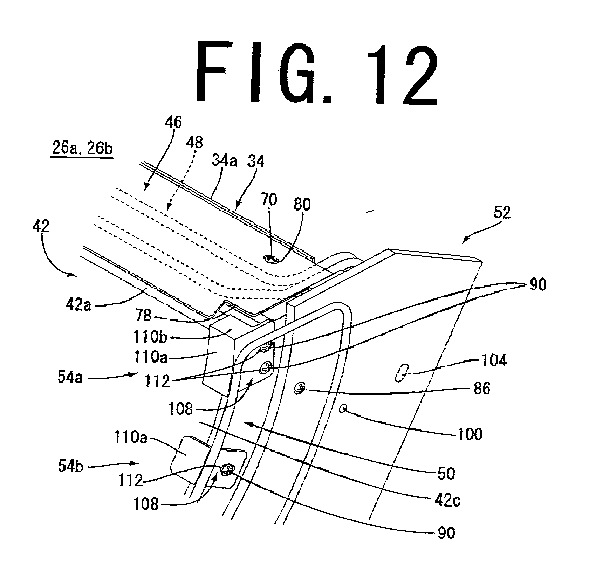

The supports 54a support the edge of axial direction of the isothermal material 42 at its edge of circumferential direction. As shown in Fig. 11 and Fig.12, each of the supports 54a includes a fixing plate 108 fixed to the axial direction separation prevent member 50, supporting plate 110a set at rights against the fixing plate 108 and arranged as to face to the inner surface 42c of the isothermal material 42, and supporting plate 110b set at rights against the fixing plate 108 and the supporting plate 110a, and arranged as to face to the end face of circumferential direction 42a of the isothermal material 42. Each of the fixing plates 108 has several holes 112 though which the fixing screw 90 pass.

The supports 54b support the edge of axial direction of the isothermal material 42 at other than its edge of circumferential direction. As shown in Fig.11 and Fig.12, each of the supports 54b includes a fixing plate 108 fixed to the axial direction separation preventing member 50, supporting plate 11 0a set at rights against the fixing plate 108 and arranged as to face to the inner surface 42c of the isothermal material 42. And the shape of each of the supports 54b is substantially "L"-letter with the fixing plate 108 and the supporting plate 110a. Each of the fixing plates 108 has several holes 112 though which the fixing screw 90 pass.

In addition, the holes 112 of the supports 54a and 54b can be mere "circular form". But it is preferred that the holes 112 are "elongate holes", because the supports 54a and 54b will be adjustable. If the holes 112 are "elongate" to radial direction, the supports 54a and 54b will be adjustable to radial direction of the isothermal material 42. As a result, the isothermal material 42 will be supported steadily.

Furthermore, the material for the supports 54a and 54b is not limited. But to prevent metal contamination of the raw material silicon 12, it is preferred to use high heat-resistant and low heat-diffusion material such as titanium or the like.

The side panel cooling pipes 56 are "pipes for passing water" made of high heat-resistant and low heat-diffusion pipes (titanium or the like). As shown in Fig.7 and Fig.11, the side panel cooling pipes 56 are arranged as to contact to all of the supports 54a and 54b. In other words, the side panel cooling pipes 56 are arranged along the outer edge and the edge of circumferential direction of the insulator 36 and the inner circumferential edge of the isothermal material 42. The both ends 56a and 56b of the side panel cooling pipes 56 are stuck out at the center part of the housing 34.

The supports 54a, 54b and the side panel cooling pipes 56 can be arranged independently each other. But in this embodiment, the side panel cooling pipes 56 are welded to the fixing plates 108 of the supports 54a and 54b. Consequently, a positioning of the cooling pipes 56 and a fixing of the supports 54a and 54b to the axial direction separation preventing members 50 can be done at one time. As a result, the positioning of the cooling pipes 56 can be easily done. And the supports 54a and 54b can be cooled efficiently with the cooling pipes 56.

The side wall members 58, as shown in Fig.7 and Fig.14, cover the end faces of axial direction 36b of the insulator 36 from the surfaces of the axial direction separation preventing members 50 and the fitting plates 52. And the side wall members 58 construct the inner wall of the heating chamber S1. The shape of each of the side wall members 58 is half-disc shape and the side wall members 58 are made of heat-resistant glass such as quartz glass or the like. The side wall member 58 for one semi-cylindrical furnace 26a has a circular cut-out 116 for leading out the wire connector 18c of the basket 18 placed in the heating chamber S1.

The covers 60, as shown in Fig.7 and Fig.14, cover the side wall members 58. Each of the covers 60 includes a half-disc shape cover plate 118 arranged to face to the side wall member 58 and a circumferential wall 120 constructs a space S5 for placing the side wall member 58. The cover plate 118 has a circular cut-out 122 corresponds to the cut-out 116 for the side wall member 58. And on outer edge of the cover plate 118, several holes for screws 124 (Fig.7) to which the fixing screws 98 are fixed are prepared. Substantially "L"-letter shaped brackets 126 are fixed on inner circumferential surface of the circumferential wall 120. And the side wall member 58 is fixed to the brackets 126.

A cover (not shown) for covering the cut-out 122 of the cover 60 may be attached to open and close the cut-out 122.

The fixing brackets 62, as shown in Fig.14, are for fixing the covers 60 and the side wall members 58 to the fitting plates 52. Each of the fixing brackets 62 is constructed as to be substantially "Z"-letter shape by connecting two fixing plates 128a and 128b with connecting plate 130. Each of the fixing plates 128a and 128b has a hole for fixing screw 98 (not shown). One fixing plate 128a is fixed to the cover 60 with the fixing screw 98 and the other fixing plate 128b is fixed to the fitting plate 52 with the fixing screw 98.

According to this embodiment, the heat of the heaters 38 is prevented from transferring directly to the housing 34 by the insulator 36 and the end faces of circumferential direction 36a and the end faces of axial direction of the insulator 36 are cooled by the cooling pipes for end face of circumferential direction 48 and the side panel cooling pipes 56. Consequently, the deforming by heat expansion of the housing 34 and the insulator 36 is prevented. And preventing from generating a gap at a joint surface between the two semi-cylindrical furnaces 26a, 26b causes a leak of the heat of the heating chamber S1 through the gap and a breakage of the heaters 38 by avoiding "bending stress" from inner surfaces of the recesses 76 (Fig.3 and Fig.6) to the heaters 38 to be avoided.

## Claims

1. A silicon heating furnace 10 having a heating chamber S1 for containing raw material silicon 12 to be heated, comprising:
two semi-cylindrical furnaces 26a, 26b constructing the cylindrical silicon heating furnace by combining each other;
**characterised in that** each of the semi-cylindrical furnaces 26a,26b has:
a semi-cylindrical housing 34;
a semi-cylindrical insulator 36 arranged in inner side of the housing 34;
a heater 38 arranged in inner side of the insulator 36;
a semi-cylindrical isothermal material 42 made of heat-resistant glass, and arranged in inner side of the heater 38 and heated by the heater 38, and constituting an inner wall of the heating chamber S1;
radial direction separation preventing members 44 arranged in inner side of both ends of circumferential direction of the housing 34, and preventing a separation of the insulator 36 to radial direction by contacting at end faces of circumferential direction 36a of the insulator 36;
end face of circumferential direction covers 46 fixed on the radial direction separation preventing members 44, and covering the end faces of circumferential direction 36a of the insulator 36; and
cooling pipes for end faces of circumferential direction 48 through which cooling water passed arranged between the end faces of circumferential direction 36a of the insulator 36 and the end face of circumferential direction covers 46.

2. The silicon heating furnace 10 according to claim 1, wherein
both of the end face of circumferential direction covers 46 and the cooling pipes for the end face of circumferential direction 48 are made of titanium and welded each other.

3. The silicon heating furnace 10 according to claim 1, further comprising
seals 40 made of string of quartz fibers arranged toward axial direction between an inner surface of the end of circumferential direction of the insulator 36 and an outer surface of the end of circumferential direction of the isothermal material 42.

4. The silicon heating furnace 10 set forth in any one of claims 1 to 3, wherein each of the two semi-cylindrical furnaces 26a, 26b comprises
axial direction separation preventing members 50 arranged at both ends of axial direction of the housing 34, preventing the insulator from being separated toward the axial direction by contacting to both end faces of axial direction 36b;
supports 54a, 54b having fixing plates 108 fitted to the axial direction separation preventing members 50 and supporting plate 110a supporting the end of axial direction of the isothermal material 42;
side panel cooling pipes 56 through which cooling water pass;
side wall members 58 made of heat-resistant glass, covering the end faces of axial direction 36b and constituting inner walls of the heating chamber S1.

5. The silicon heating furnace 10 according to claim 4, wherein
the supports 54a, 54b and the side panel cooling pipes 56 are made of titanium and welded to each other.

## Patentansprüche

1. Siliziumheizofen 10 mit einer Heizkammer S1 für das Aufnehmen des zu erhitzenden Rohmaterials Silizium 12, der aufweist:
zwei halbzylindrische Öfen 26a, 26b, die den zylindrischen Siliziumheizofen durch Kombinieren miteinander aufbauen;
**dadurch gekennzeichnet, dass** ein jeder der halbzylindrischen Öfen 26a, 26b aufweist:
ein halbzylindrisches Gehäuse 34;
einen halbzylindrischen Isolator 36, der in der Innenseite des Gehäuses 34 angeordnet ist; einen Heizkörper 38, der in der Innenseite des Isolators 36 angeordnet ist;
ein halbzylindrisches isothermes Material 42, das aus hitzbeständigem Glas besteht und in der Innenseite des Heizkörpers 38 angeordnet und durch den Heizkörper 38 erhitzt wird und eine Innenwand der Heizkammer S1 bildet;
Elemente 44 zur Verhinderung einer Trennung in der radialen Richtung, die in der Innenseite der beiden Enden der Umfangsrichtung des Gehäuses 34 angeordnet sind und eine Trennung des Isolators 36 zur radialen Richtung verhindern, indem an den Endflächen der Umfangsrichtung 36a des Isolators 36 ein Kontakt erfolgt;
eine Endfläche der Umfangsrichtungsdeckel 46, die an den Elementen 44 zur Verhinderung einer Trennung in der radialen Richtung befestigt ist und die Endflächen der Umfangsrichtung 36a des Isolators 36 bedeckt; und
Kühlrohre für die Endflächen der Umfangsrichtung 48, durch die Kühlwasser geführt wird, angeordnet zwischen den Endflächen der Umfangsrichtung 36a des Isolators 36 und der Endfläche der Umfangsrichtungsdeckel 46.

2. Siliziumheizofen 10 nach Anspruch 1, bei dem sowohl die Endfläche der Umfangsrichtungsdeckel 46 als auch die Kühlrohre für die Endfläche der Umfangsrichtung 48 aus Titan bestehen und miteinander verschweißt sind.

3. Siliziumheizofen 10 nach Anspruch 1, der außerdem aufweist:
Dichtungen 40 aus einem Strang von Quarzfasern, die zur axialen Richtung hin zwischen einer Innenfläche des Endes der Umfangsrichtung des Isolators 36 und einer Außenfläche des Endes der Umfangsrichtung des isothermen Materials 42 angeordnet sind.

4. Siliziumheizofen 10 nach einem der Ansprüche 1 bis 3, bei dem ein jeder der zwei halbzylindrischen Öfen 26a, 26b aufweist:
Elemente 50 zur Verhinderung einer Trennung in der axialen Richtung, die an beiden Enden der axialen Richtung des Gehäuses 34 angeordnet sind, wobei verhindert wird, dass sich der Isolator zur axialen Richtung hin trennt, indem an beiden Endflächen der axialen Richtung 36b ein Kontakt erfolgt;
Halterungen 54a, 54b mit Befestigungsplatten 108, die an den Elementen 50 zur Verhinderung einer Trennung in der axialen Richtung befestigt sind, und eine Halteplatte 110a, die das Ende der axialen Richtung des isothermen Materials 42 trägt;
Seitenplattenkühlrohre 56, durch die das Kühlwasser gelangt;
Seitenwandelemente 58 aus hitzebeständigem Glas, die die Endflächen der axialen Richtung 36b bedecken und die Innenwände der Heizkammer S1 bilden.

5. Siliziumheizofen 10 nach Anspruch 4, bei dem die Halterungen 54a, 54b und die Seitenplattenkühlrohre 56 aus Titan bestehen und aneinander geschweißt sind.

## Revendications

1. Four de chauffage de silicium 10, comportant une chambre de chauffage S1 pour contenir le matériau de silicium brut devant être chauffé 12, comprenant :
deux fours semi-cylindriques 26a, 26b, constituant le four de chauffage de silicium cylindrique lors d'une combinaison mutuelle ;
**caractérisé en ce que** chacun des fours semi-cylindriques 26a, 26b comporte :
un boîtier semi-cylindrique 34 ;
un isolant semi-cylindrique 36, agencé dans le côté interne du boîtier 34 ;
un dispositif de chauffage 38, agencé sur le côté interne de l'isolant 36 ;
un matériau isotherme semi-cylindrique 42, composé de verre réfractaire, et agencé sur le côté interne du dispositif de chauffage 38, chauffé par le dispositif de chauffage 38 et constituant une paroi interne de la chambre de chauffage S1 ;
des éléments empêchant une séparation dans la direction radiale 44, agencés sur le côté interne des deux extrémités dans la direction radiale du boîtier 34, et empêchant une séparation du moyen isolant dans la direction radiale par l'établissement d'un contact au niveau des faces d'extrémité dans la direction circonférentielle 36a de l'isolant 36 ; et
la face d'extrémité des couvercles dans la direction circonférentielle 46, fixés sur les éléments empêchant une séparation dans la direction radiale 44, et recouvrant les faces d'extrémité dans la direction circonférentielle 36a de l'isolant 36 ; et
des conduites de refroidissement pour les faces d'extrémité dans la direction circonférentielle 48, à travers lesquelles passe l'eau de refroidissement, agencées entre les faces d'extrémité dans la direction circonférentielle 36a de l'isolant 36 et la face d'extrémité des couvercles dans la direction circonférentielle 46.

2. Four de chauffage de silicium 10 selon la revendication 1, dans lequel
à la fois la face d'extrémité des couvercles dans la direction circonférentielle 46 ainsi que les conduites de refroidissement pour la face d'extrémité dans la direction circonférentielle 48 sont composés de titane et sont assemblés par soudage.

3. Four de chauffage de silicium 10 selon la revendication 1, comprenant en outre
des joints d'étanchéité 40 composés d'un cordon de fibres de quartz, agencés dans la direction axiale entre une surface interne de l'extrémité dans la direction circonférentielle de l'isolant 36 et une surface externe de l'extrémité dans la direction circonférentielle du matériau isotherme 42.

4. Four de chauffage de silicium 10 selon l'une quelconque des revendications 1 à 3, dans lequel
chacun des deux fours semi-cylindriques 26a, 26b comprend
des éléments empêchant une séparation dans la direction axiale 50, agencés au niveau des deux extrémités dans la direction axiale du boîtier 34, empêchant une séparation de l'isolant dans la direction axiale par l'établissement d'un contact avec les deux faces d'extrémité dans la direction axiale 36b ;
des supports 54a, 54b comportant des plaques de fixation 108 fixées sur les éléments empêchant une séparation dans la direction axiale 50, et une plaque de support 110a supportant l'extrémité dans la direction axiale du matériau isotherme 42 ;
des conduites de refroidissement de panneau latéral 56 à travers lesquelles passe l'eau de refroidissement ;
des éléments de paroi latérale 58, composés de verre réfractaire, recouvrant les faces d'extrémité dans la direction axiale 36b et constituant des parois internes de la chambre de chauffage S1.

5. Four de chauffage de silicium 10 selon la revendication 4, dans lequel les supports 54a, 54b et les conduites de refroidissement du panneau latéral 56 sont composés de titane et sont assemblés par soudage.
